# EUROPÄISCHE PATENTSCHRIFT

(11) **EP 1 747 438 B1**
(45) Veröffentlichungstag und Bekanntmachung des Hinweises auf die Patenterteilung: **29.06.2011**
(21) Anmeldenummer: 05744177.6
(22) Anmeldetag: 19.05.2005
(51) Int. Cl.: G01K 7/02

(54) **TEMPERATURSENSOR UND TEMPERATURÜBERWACHUNGSVORRICHTUNG**
TEMPERATURE SENSOR AND TEMPERATURE MONITORING DEVICE
CAPTEUR DE TEMPERATURE ET DISPOSITIF DE SURVEILLANCE DE TEMPERATURE

(30) Priorität: 21.05.2004 DE 102004024955
(43) Veröffentlichungstag der Anmeldung: 31.01.2007
(73) Patentinhaber: Trumpf Laser- und Systemtechnik GmbH, 71254 Ditzingen (DE)
(72) Erfinder: ZELLER, Thomas, 71067 Sindelfingen (DE); FINKE-BEHRENDS, Tanja, 33729 Bielefeld (DE)
(74) Vertreter: Kohler Schmid Möbus
(86) Internationale Anmeldenummer: PCT/EP2005/005427
(87) Internationale Veröffentlichungsnummer: WO 2005/114123

(56) Entgegenhaltungen:
- DD-A1- 219 282
- DE-A1- 4 427 181
- DE-A1- 10 219 011
- US-A- 5 370 459
- US-A- 6 152 597
- US-A1- 2002 071 475

## Beschreibung

Die vorliegende Erfindung betrifft eine Temperaturüberwachungsvorrichtung gemäß Oberbegriff von Anspruch 1 und einen Gaslaserresonator mit einer solchen Temperaturüberwachungsvorrichtung für mindestens einen Spiegel des Gaslaserresonators.

Eine derartige Temperaturüberwachungsvorrichtung ist beispielsweise durch die US 2002/071475 A1 bekannt geworden.

Diese bekannte Temperaturüberwachungsvorrichtung umfasst eine flexible Leiterplatte mit einem Basisbereich am proximalen Ende und einem Messbereich am distalen Ende, einen Sensorschaltkreis mit mehreren Leiterbahnen, welche auf der Leiterplatte befestigt sind und im Basisbereich als "Tracepads" enden, und einen Anschluss zum Kontaktieren der Tracepads. Ein Sensor ist im Messbereich befestigt und steht in elektrischem Kontakt zu den Leiterbahnen.

Aus der DE 44 27 181 A1 ist noch eine Vorrichtung zur Halterung der Messspitze eines Thermoelements an einem Bauteil bekannt. Die Messspitze ist mittels eines Trägerbandes eng am Bauteil angebracht und entweder auf der vom Bauteil wegweisenden Oberfläche des Trägerbandes mit einer Haltefolie befestigt oder in einer Bohrung des Trägerbandes angeordnet.

Weiter ist als PT100 ein Temperatursensor mit zwei Anschlussdrähten bekannt, die bei Verwendung im Vakuum aufwändig mit teflonummantelten Kabeln angeschlossen (verlötet) werden müssen, da andere Kabel im Vakuum ausgasen. Um die Lötstellen elektrisch zu isolieren, werden diese mittels Teflon-Schrumpfschlauch überzogen. Das Löten und Schrumpfen der Kabel ist aufwändig und für eine Serienfertigung unwirtschaftlich.

Demgegenüber ist es die Aufgabe der vorliegenden Erfindung, eine Temperaturüberwachungsvorrichtung der eingangs genannten Art zur Überwachung eines Spiegels weiterzubilden.

Diese Aufgabe wird erfindungsgemäß gelöst durch eine Temperaturüberwachungsvorrichtung mit den Merkmalen von Anspruch 1. Das biegsame Leiterplattenband ist so dünn ausgeführt, dass die thermische Isolationswirkung keinen wesentlichen Einfluss auf die Temperaturmessung hat.

Eine Spiegelverschmutzung durch einen gleichmäßigen Belag oder durch einen einzelnen Einbrand führt zu einer erhöhten Absorption eines auf den Spiegel treffenden Laserstrahls, wodurch mehr Leistung über den Spiegel abgeführt wird und dessen Temperatur ansteigt. Wenn diese Temperaturerhöhung einen vorbestimmten Grenzwert übersteigt, wird von der Temperaturüberwachungsvorrichtung ein entsprechendes Fehlersignal generiert. Da die Vorderseite des Spiegels im Bereich der Laserstrahlung liegt, bietet sich als Messstelle die Spiegelrückseite oder -mantelfläche an.

Vorzugsweise ist das Thermoelement ein PT100 und ein SMD(Surface Mounted Device)-Bauteil, das auf freiliegenden Kontaktflächen des biegsamen Leiterplattenbands befestigt, insbesondere aufgelötet, ist. Bei einem Thermoelement in SMD-Bauform sind die Anschlüsse als beidseitige Lötkappen ausgeführt, die bei direktem Kontakt mit dem elektrisch leitfähigen Spiegelmaterial zu einem Kurzschluss bzw. Parallelwiderstand führen und keine Messung zulassen würden. Erfindungsgemäß ist das biegsame Leiterplattenband als elektrischer Isolator zwischen Thermoelement und Bauteil gelegt.

Vorzugsweise ist das biegsame Leiterplattenband aus ausgasungsfreiem Material, insbesondere Teflon, gebildet. Bei Anordnung des Temperatursensors in einem CO₂-Laser besteht das biegsame Leiterplattenband vorteilhafterweise ebenfalls aus Teflon, das im Gegensatz zum üblicherweise verwendeten KAPTON resistent gegen die im Resonator herrschende Gasatmosphäre ist.

Bei einer besonders bevorzugten Ausführungsform der erfindungsgemäßen Temperaturüberwachungsvorrichtung verlaufen die Anschlussleitungen als Leiterbahnen auf dem biegsamen Leiterplattenband. Dabei sind die Leiterbahnen, außer ihren elektrischen Kontaktstellen für das Thermoelement, mit einer elektrisch isolierenden Beschichtung, insbesondere mit einem Lack, versehen, so dass die Anschlussleitungen nach außen elektrisch isoliert sind.

Vorzugsweise ist ein Federelement vorgesehen, welches das Thermoelement in Richtung gegen den Spiegel drückt, um so einen guten thermischen Kontakt des Temperatursensors mit dem Spiegel sicherzustellen.

Besteht z.B. bei einem gefalteten CO₂-Laser mit mehreren Umlenkspiegeln der Verdacht, dass ein oder mehrere Umlenkspiegel verschmutzt sind bzw. Einbrände aufweisen, werden in der Regel vorsorglich alle Umlenkspiegel ausgetauscht. Allerdings muss dazu das Vakuumsystem des Gaslaserresonators geöffnet werden, so dass Partikel in den Resonator gelangen und ihn verschmutzen können. Diese Resonatorverunreinigung kann wiederum zu einem erneuten Spiegeldefekt führen. Die Spiegelauflageflächen sind diamantgefräst und können durch Partikel, die beim Spiegelwechsel zwischen Spiegel und Auflage gelangen, zerkratzt werden. Diese Kratzer können zu einer undefinierten Spiegelanlage und damit zu einer Dejustage des Resonators führen.

Die Erfindung betrifft auch einen Gaslaserresonator mit mindestens zwei Spiegeln und einer wie oben ausgebildeten Temperaturüberwachungsvorrichtung zur Überwachung der Temperatur mindestens eines Spiegels. Bei einer Spiegelverschmutzung wird mehr Leistung am Spiegel absorbiert. Dies führt am Spiegel zu einer Temperaturerhöhung, die von der Temperaturüberwachungsvorrichtung detektiert wird.

Vorzugsweise steht der Temperatursensor in thermischem Kontakt mit der Rückseite oder der Mantelfläche des überwachten Spiegels.

Besonders bevorzugt ist jedem Umlenkspiegel des Gaslaserresonators ein Temperatursensor der Temperaturüberwachungsvorrichtung zugeordnet. So kann bei einer Verschmutzung eines einzelnen Spiegels (z.B. durch einen Einbrand eines Partikels) dieser detektiert und gezielt getauscht werden. Neben der Einsparung durch die reduzierte Anzahl an getauschten Spiegeln muss das Vakuumsystem des Gaslaserresonators nicht mehr so lange geöffnet werden, wodurch die Gefahr der Resonatorverschmutzung reduziert ist. Da nur noch die beschädigten Spiegel getauscht werden müssen, besteht bei den restlichen Spiegeln keine Gefahr mehr, die Spiegelauflagen zu zerkratzen.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: einen Temperatursensor der erfindungsgemäßen Temperaturüberwachungsvorrichtung;
- Fig. 2: die erfindungsgemäße Temperaturüberwachungsvorrichtung zur Temperaturüberwachung eines Umlenkspiegels mittels des in Fig. 1 gezeigten Temperatursensors; und
- Fig. 3: einen Gaslaserresonator mit mehreren Spiegeln, deren Temperatur mittels der in Fig. 2 gezeigten Vorrichtung überwacht wird.

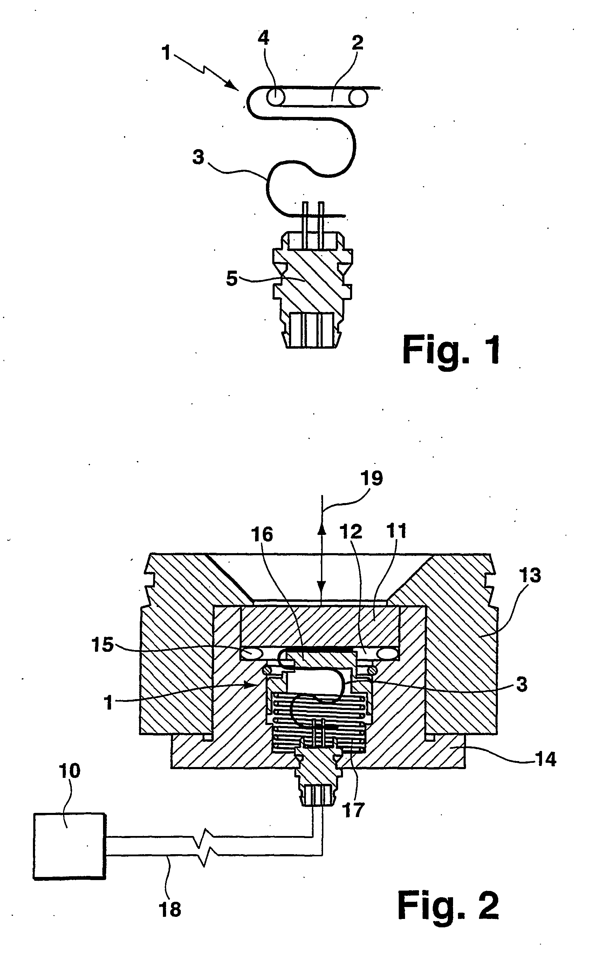

Der in **Fig. 1** gezeigte Temperatursensor **1** weist ein Thermoelement **2,** bevorzugt ein Platin-Thermoelement (z.B. PT100), und ein biegsames Leiterplattenband (Flexplatine) **3** auf. Das Thermoelement **2** ist ein SMD(Surface Mounted Device)-Bauteil und auf Kontakte des biegsamen Leiterplattenbands 3 aufgelötet (Lötkappen **4**), in das die Anschlussleitungen des Thermoelements 2 integriert sind. Das biegsame Leiterplattenband 3 besteht aus ausgasungsfreiem, elektrisch isolierendem Material (z.B. Teflon), auf dem die Leiterbahnen verlaufen. Das Leiterplattenband 3 wird durch einen Lötstoplack elektrisch isoliert. Sämtliche Bereiche des Leiterplattenbandes 3, außer den Lötstellen, sind von diesem Lack umgeben. Am freien Ende weist das biegsame Leiterplattenband **3** einen Stecker **5** auf, um den Temperatursensor 1 an die in **Fig. 2** gezeigte Temperaturüberwachungsvorrichtung **10** über Leitungen **18** anzuschließen.

Die Vorrichtung 10 dient zur Temperaturüberwachung eines Umlenkspiegels **11** mittels des Temperatursensors 1, dessen Thermoelement 2 in thermischem Kontakt mit dem Umlenkspiegel 11 angeordnet ist. Der Umlenkspiegel 11 ist in einer Öffnung **12** einer Spiegelaufnahme **14** axial verschiebbar geführt und mittels einer an der Spiegelaufnahme 14 abgestützten Axialfeder **15** in Anlage an einen Spiegelträger **13** gedrückt. Das Thermoelement 2 ist zwischen der Rückseite des Umlenkspiegels 11 und einem Temperatursensorträger **16** angeordnet, der in der Spiegelaufnahme **14** axial verschiebbar geführt und durch ein Federelement (Schraubenfeder) **17** in Richtung Umlenkspiegel 11 gedrückt wird. Dadurch wird das Thermoelement 2 an den Umlenkspiegel 11 angedrückt, wodurch ein guter thermischer Kontakt gewährleistet ist. Bevorzugt ist das biegsame Leiterplattenband 3 auf den Temperatursensorträger 16 geklemmt. Der Temperatursensorträger 16 ist aus einem nicht leitfähigen Material (z.B. PEEK) aufgebaut.

Da die beidseitigen Lötkappen 4 des Thermoelements 2 bei direktem Kontakt mit der elektrisch leitfähigen Rückseite des Umlenkspiegels 11 zu einem Kurzschluss bzw. Parallelwiderstand führen und keine Messung zulassen würden, ist das biegsame Leiterplattenband 3 als elektrischer Isolator zwischen Thermoelement 2 und Umlenkspiegel 11 gelegt, wie auch in Fig. 1 gezeigt ist. Das biegsame Leiterplattenband 3 ist so dünn ausgeführt, dass seine thermische Isolationswirkung keinen wesentlichen Einfluss auf die Temperaturmessung hat. Weiterhin kann durch das biegsame Leiterplattenband 3 die zur Montage/Demontage erforderliche Bewegung des Umlenkspiegels 11 um ca. 1 mm gegen die Axialfeder 15 ausgeglichen werden.

Eine Spiegelverschmutzung durch einen gleichmäßigen Belag oder durch einen einzelnen Einbrand führt zu einer erhöhten Absorption eines auf den Umlenkspiegel 11 treffenden Laserstrahls **19,** wodurch mehr Leistung über den Umlenkspiegel 11 abgeführt wird und dessen Temperatur ansteigt. Wenn diese Temperaturerhöhung einen vorbestimmten Grenzwert übersteigt, wird ein entsprechendes Fehlersignal von der Temperaturüberwachungsvorrichtung 10 generiert. Statt mit der Spiegelrückseite kann der Temperatursensor 1 auch mit der Mantelfläche des Umlenkspiegels 11 in thermischem Kontakt stehen.

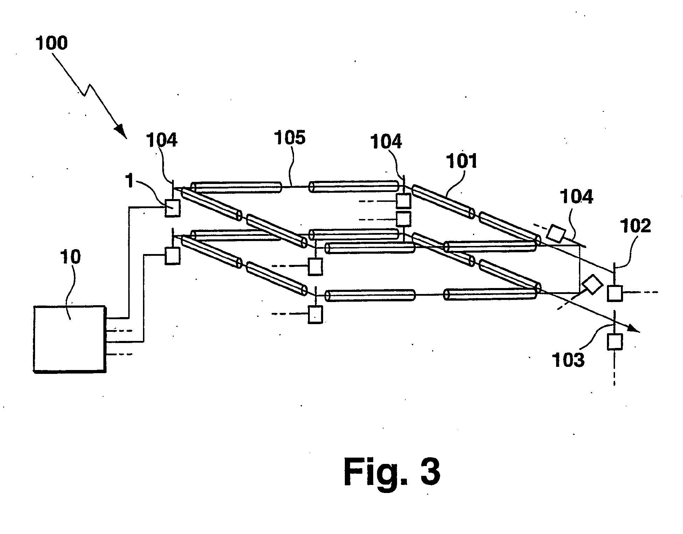

**Fig. 3** zeigt einen quadratisch gefalteten Gaslaserresonator **100,** dessen Entladungsrohre **101** in zwei Ebenen angeordnet sind. Der Gaslaserresonator 100 hat einen Rückspiegel **102,** einen Auskoppelspiegel **103** und acht Umlenkspiegel **104.** Der Rückspiegel 102, der Auskoppelspiegel 103 und die Umlenkspiegel 104 weisen jeweils einen Temperatursensor 1 auf, der an die Temperaturüberwachungsvorrichtung 10 angeschlossen ist. Die Temperaturüberwachungsvorrichtung 10 bestimmt für jeden Spiegel 102, 103, 104 einen räumlich gemittelten Temperaturwert. Der Temperaturwert kann automatisch oder manuell ausgewertet werden. Beispielsweise bietet sich ein Vergleich des Temperaturwertes mit einem Referenzwert aus der Inbetriebnahme desselben Spiegels oder ein Vergleich mehrerer Spiegel untereinander an. Übersteigt die gemessene Temperatur eines Spiegels 102, 103, 104 den vorbestimmten Grenzwert, gibt die Temperaturüberwachungsvorrichtung 10 ein Fehlersignal für diesen Spiegel aus, der dann gezielt ausgetauscht werden kann. Bei teiltransmissiven Rück- und Auskoppelspiegeln wird der Temperatursensor an der Mantelfläche des Spiegels angeordnet, die Spiegelrückseite ist aufgrund der hindurchtretenden Laserstrahlung nicht zur Temperaturmessung geeignet.

## Patentansprüche

1. Temperaturüberwachungsvorrichtung (10), umfassend:
ein Bauteil (11; 102, 103, 104) und
einen in thermischem Kontakt mit dem Bauteil (11; 102, 103, 104) stehenden Temperatursensor (1), der ein Thermoelement (2) und Anschlussleitungen aufweist, wobei das Thermoelement (2) elektrisch leitend auf ein biegsames Leiterplattenband (3) aufgebracht ist, in das die Anschlussleitungen integriert sind,
**dadurch gekennzeichnet,**
**dass** das Bauteil (11; 102, 103, 104) ein Spiegel ist und dass das biegsame Leiterplattenband (3) als elektrischer Isolator zwischen Thermoelement (2) und Spiegel (11; 102, 103, 104) angeordnet ist.

2. Temperaturüberwachungsvorrichtung nach Anspruch 1, **dadurch gekennzeichnet, dass** das Thermoelement (2) ein SMD-Bauteil ist, das auf freiliegenden Kontaktflächen des biegsamen Leiterplattenbands (3) befestigt, insbesondere aufgelötet, ist.

3. Temperaturüberwachungsvorrichtung nach Anspruch 1 oder 2, **dadurch gekennzeichnet, dass** das biegsame Leiterplattenband (3) aus ausgasungsfreiem Material, insbesondere Teflon, gebildet ist.

4. Temperaturüberwachungsvorrichtung nach einem der vorhergehenden Ansprüche, **dadurch gekennzeichnet, dass** das Thermoelement (2) ein PT100-Thermoelement ist.

5. Temperaturüberwachungsvorrichtung nach einem der vorhergehenden Ansprüche, **dadurch gekennzeichnet, dass** das biegsame Leiterplattenband (3) endseitig einen Stecker (5) aufweist.

6. Temperaturüberwachungsvorrichtung nach einem der vorhergehenden Ansprüche, **dadurch gekennzeichnet, dass** die Anschlussleitungen als Leiterbahnen auf dem biegsamen Leiterplattenband (3) verlaufen und die Leiterbahnen, außer ihren elektrischen Kontaktstellen für das Thermoelement (2), mit einer elektrisch isolierenden Beschichtung, insbesondere mit einem Lack, versehen sind.

7. Temperaturüberwachungsvorrichtung nach einem der vorhergehenden Ansprüche, **gekennzeichnet durch** ein Federelement (17), das den Temperatursensor (1) in Richtung gegen den Spiegel (11; 102, 103, 104) drückt.

8. Gaslaserresonator (100) mit mindestens zwei Spiegeln (102, 103, 104) und einer die Temperatur mindestens eines Spiegels (102, 103, 104) überwachenden Temperaturübervvachungsvorrichtung (10) nach einem der Ansprüche 1 bis 7.

9. Gaslaserresonator nach Anspruch 8, **dadurch gekennzeichnet, dass** der Temperatursensor (1) in thermischem Kontakt mit der Rückseite oder der Mantelfläche des überwachten Spiegels (102, 103, 104) steht.

10. Gaslaserresonator nach Anspruch 8 oder 9, **dadurch gekennzeichnet, dass** jedem Spiegel (102, 103, 104) des Gaslaserresonators (100) ein Temperatursensor (1) der Temperaturüberwachungsvorrichtung (10) zugeordnet ist.

## Claims

1. Temperature monitoring device (10) comprising:
a component (11; 102, 103, 104) and
a temperature sensor (1) that is in thermal contact with the component (11; 102, 103, 104) and has a thermocouple (2) and connecting lines, wherein the thermocouple (2) is mounted in an electrically conducting fashion onto a flexible printed circuit board tape (3) in which the connecting lines are integrated,
**characterized in that**
the component (11; 102, 103, 104) is a mirror and the flexible printed circuit board tape (3) is mounted as an electrical insulator between the thermocouple (2) and the mirror (11; 102, 103, 104).

2. Temperature monitoring device according to claim 1, **characterized in that** the thermocouple (2) is an SMD component that is mounted, in particular soldered, to exposed contact surfaces of the flexible printed circuit board tape (3).

3. Temperature monitoring device according to claim 1 or 2, **characterized in that** the flexible printed circuit board tape (3) is formed from emission-free material, in particular Teflon.

4. Temperature monitoring device according to any one of the preceding claims, **characterized in that** the thermocouple (2) is a PT100 thermocouple.

5. Temperature monitoring device according to any one of the preceding claims, **characterized in that** a connector (5) is provided at one end of the flexible printed circuit board tape (3).

6. Temperature monitoring device according to any one of the preceding claims, **characterized in that** the connecting lines extend in the form of conducting paths on the flexible printed circuit board tape (3) and the conducting paths are provided with an electrically insulating coating, in particular with a lacquer, except at electric contact points with the thermocouple (2).

7. Temperature monitoring device according to any one of the preceding claims, **characterized by** a spring element (17) which forces the temperature sensor (1) towards the mirror (11; 102, 103, 104).

8. Gas laser resonator (100) comprising at least two mirrors (102, 103, 104) and a temperature monitoring device (10) according to any one of the claims 1 through 7, which monitors the temperature of at least one mirror (102, 103, 104).

9. Gas laser resonator according to claim 8, **characterized in that** the temperature sensor (1) is in thermal contact with the rear side or the lateral surface of the monitored mirror (102, 103, 104).

10. Gas laser resonator according to claim 8 or 9, **characterized in that** each mirror (102, 103, 104) of the gas laser resonator (100) is associated with a temperature sensor (1) of the temperature monitoring device (10).

## Revendications

1. Dispositif de surveillance de température (10), comprenant :
un composant (11 ; 102, 103, 104) et
un capteur de température (1) en contact thermique avec le composant (11 ; 102, 103, 104), qui présente un thermo-élément (2) et des lignes de raccordement, le thermo-élément (2) étant appliqué de manière électroconductrice sur une bande de carte de circuit imprimé flexible (3) dans laquelle les lignes de raccordement sont intégrées,
**caractérisé en ce**
**que** le composant (11 ; 102, 103, 104) est un miroir et que la bande de carte de circuit imprimé flexible (3) est disposée en tant qu'isolateur électrique entre le thermo-élément (2) et le miroir (11 ; 102, 103, 104).

2. Dispositif de surveillance de température selon la revendication 1, **caractérisé en ce que** le thermo-élément (2) est un composant CMS qui est fixé, en particulier soudé, sur des surfaces de contact découvertes de la bande de carte de circuit imprimé flexible (3).

3. Dispositif de surveillance de température selon la revendication 1 ou 2, **caractérisé en ce que** la bande de carte de circuit imprimé flexible (3) est formée d'un matériau sans émanation de gaz, en particulier de téflon.

4. Dispositif de surveillance de température selon une des revendications précédentes, **caractérisé en ce que** le thermo-élément (2) est un thermo-élément PT100.

5. Dispositif de surveillance de température selon une des revendications précédentes, **caractérisé en ce que** la bande de carte de circuit imprimé flexible (3) présente un connecteur (5) à une extrémité.

6. Dispositif de surveillance de température selon une des revendications précédentes, **caractérisé en ce que** les lignes de raccordement s'étendent sous la forme de pistes conductrices sur la bande de carte de circuit imprimé flexible (3) et les pistes conductrices sont munies, en dehors de leurs points de contact électriques pour le thermo-élément (2), d'un revêtement électriquement isolant, en particulier d'un vernis.

7. Dispositif de surveillance de température selon une des revendications précédentes, **caractérisé par** un élément à ressort (17) qui pousse le capteur de température (1) en direction du miroir (11 ; 102, 103, 104).

8. Résonateur de laser à gaz (100) comportant au moins deux miroirs (102, 103, 104) et un dispositif de surveillance de température (10) selon une des revendications 1 à 7 qui surveille la température d'au moins un miroir (102, 103, 104).

9. Résonateur de laser à gaz selon la revendication 8, **caractérisé en ce que** le capteur de température (1) est en contact thermique avec la face arrière ou la surface d'enveloppe du miroir (102, 103, 104) surveillé.

10. Résonateur de laser à gaz selon la revendication 8 ou 9, **caractérisé en ce qu'**un capteur de température (1) du dispositif de surveillance de température (10) est associé à chaque miroir (102, 103, 104) du résonateur de laser à gaz (100).
